# EUROPEAN PATENT SPECIFICATION

(11) **EP 4 329 206 B1**
(45) Date of publication and mention of the grant of the patent: **30.07.2025**
(21) Application number: 23777128.2
(22) Date of filing: 19.06.2023
(51) Int. Cl.: H04B 1/40, H04L 27/12, H03L 7/097, H03L 7/099

(54) **WIRELESS COMMUNICATION DEVICE AND METHOD FOR CONTROLLING ACTIVATION OF RF TRANSMISSION SIGNAL GENERATION CIRCUIT**
DRAHTLOSE KOMMUNIKATIONSVORRICHTUNG UND VERFAHREN ZUR STEUERUNG DER AKTIVIERUNG EINER HF-ÜBERTRAGUNGSSIGNALERZEUGUNGSSCHALTUNG
DISPOSITIF DE COMMUNICATION SANS FIL ET PROCÉDÉ DE COMMANDE D'ACTIVATION D'UN CIRCUIT DE GÉNÉRATION DE SIGNAL DE TRANSMISSION RF

(30) Priority: 20.06.2022 KR 20220075175; 26.07.2022 KR 20220092649
(43) Date of publication of application: 28.02.2024
(73) Proprietor: Samsung Electronics Co., Ltd., Suwon-si, Gyeonggi-do 16677 (KR)
(72) Inventor: LEE, Youngmin, Gyeonggi-do 16677 (KR); NA, Hyoseok, Gyeonggi-do 16677 (KR); YOOK, Gunun, Gyeonggi-do 16677 (KR)
(74) Representative: Nederlandsch Octrooibureau
(86) International application number: PCT/KR2023/008416
(87) International publication number: WO 2023/249341

(56) References cited:
- KR-A- 20150 086 838
- KR-A- 20150 086 838
- KR-A- 20180 049 129
- KR-A- 20210 034 991
- KR-A- 20210 034 991
- US-A1- 2012 282 866
- US-B1- 9 219 487
- US-B1- 9 401 801

## Description

### Technical Field

Various embodiments of the present disclosure relate to a technology for controlling activation of a radio frequency (RF) transmission signal generation circuit and a wireless communication device performing the same.

### Background Art

In a wireless communication device, a communication processor may perform communication-related control. A signal generated by the communication processor may be used to control a transceiver and radio frequency (RF) components. The transceiver, a device configured to transmit and receive wireless communication signals, may implement the functions of a transmitter and a receiver as a single module. The RF components may include an RF front end. In general, the RF front end refers to all the components between an antenna and the transceiver and may perform functions such as networking, file transfer, communication, card swipe, and/or positioning.

KR 2021 0034991 A, 31 March 2021, is about an electronic device which may include an antenna, a duplexer, a power amplification circuit, a processor, and a transceiver coupled to the processor and the power amplification circuit. The transceiver may include: a first phase locked loop (PLL) circuit; a first mixer; a detection circuit; a second phase locked loop (PLL) circuit; a second mixer; a first filter; and a second filter.

KR 2015 0086838 A, 29 July 2015, is about a digital phase lock loop (digital PLL) for an ultra-low power transceiver. According to an embodiment, a phase lock loop (PLL) includes a counter which measures voltage controlled oscillator (VCO) information on an oscillator during mask time, and a frequency tuner which controls a target frequency with the frequency of the oscillator according to a comparison result of the VOC and the target frequency information previously stored in a mapping table.

### Disclosure of Invention

### Technical Goals

When there is a control problem such as a software code error or a timing alignment error in a process of controlling a transceiver by a communication processor, a failure may occur in performing wireless communication. When there is such a problem in a control process relating to a radio frequency (RF) transmission signal, RF components may be damaged.

A wireless communication device and a method for controlling activation of an RF transmission signal generation circuit according to an embodiment may employ a hardware control method for a transceiver and may therefore reduce the damage that may occur in RF components due to an issue occurring in a control process relating to an RF transmission signal.

### Technical Solutions

According to an embodiment, there is provided a wireless communication device including: a communication processor; and a transceiver configured to be controlled by the communication processor to perform wireless communication, wherein the transceiver includes: a phase locked loop (PLL) circuit configured to generate a first oscillator signal based on a clock frequency signal; a radio frequency (RF) transmission signal generation circuit configured to generate an RF transmission signal based on the first oscillator signal received from the PLL circuit and a baseband transmission signal received from the communication processor; and a first decision circuit configured to receive a first phase comparison signal indicating whether a phase of the first oscillator signal is locked from a first phase comparator in the PLL circuit, and control activation of at least one component included in the RF transmission signal generation circuit based on the first phase comparison signal.

According to an embodiment, there is provided a method of controlling activation of an RF transmission signal generation circuit included in a transceiver of a wireless communication device configured to perform wireless communication, the method including: comparing, by a first phase comparator in a PLL circuit of the transceiver, a phase of a clock frequency signal and a phase of a first oscillator signal that is an output signal of the PLL circuit, and generating a first phase comparison signal indicating whether the phase of the first oscillator signal is locked; transferring, by the first phase comparator, the first phase comparison signal to a first decision circuit of the transceiver; controlling, by the first decision circuit, activation of at least one component included in the RF transmission signal generation circuit based on whether the phase of the first oscillator signal indicated in the first phase comparison signal is locked; in response to the at least one component being activated, generating, by the RF transmission signal generation circuit, an RF transmission signal from the first oscillator signal and a baseband transmission signal generated by a communication processor of the wireless communication device; and outputting, by the RF transmission signal generation circuit, the generated RF transmission signal.

### Effects of Invention

A wireless communication device and a method for controlling activation of a radio frequency (RF) transmission signal generation circuit according to an embodiment may control activation of the RF transmission signal generation circuit when a transmission signal of a frequency out of a normal range is generated due to an error generated in a control process relating to an RF transmission signal, and may therefore reduce damage to components of the RF transmission signal generation circuit.

### Brief Description of Drawings

FIG. 1 is a diagram illustrating a configuration of a wireless communication device.
FIG. 2 is a diagram illustrating a first decision circuit configured to control activation of a radio frequency (RF) transmission signal generation circuit.
FIG. 3 is a diagram illustrating components of an RF transmission signal generation circuit for which a first decision circuit controls activation.
FIG. 4 is a diagram illustrating an input and output of a first decision circuit.
FIG. 5 is a diagram illustrating a first decision circuit.
FIG. 6 is a diagram illustrating an input and output of a first decision circuit.
FIG. 7 is a diagram illustrating a first decision circuit and a second decision circuit.
FIG. 8 is a diagram illustrating an example case in which a baseband signal frequency is out of a normal range by a first frequency shifter and a second frequency shifter.
FIG. 9 is a diagram illustrating an input and output of a first decision circuit.
FIG. 10 is a flowchart illustrating a method of controlling activation of an RF transmission signal generation circuit.
FIG. 11 is a block diagram illustrating an electronic device including a wireless communication device.

### Best Mode for Carrying Out Invention

Hereinafter, examples/embodiments will be described in detail with reference to the accompanying drawings. When describing the embodiments with reference to the accompanying drawings, like reference numerals refer to like elements and a repeated description related thereto will be omitted.

The person skilled in the art will understand that the features described above and/or below may be combined in any way deemed useful. The drawings of the present disclosure show examples/embodiments of the invention, which will be described in detail hereinafter. It is to be understood that one or more of elements / components shown and/or described in one or more of these examples/embodiments and not in others may be used in those others too unless mechanical or other limitations prevent such an implementation. Moreover, describing features of different examples/embodiments in a single passage does not automatically mean that those features are inextricably linked. They may be applied separately from one another.

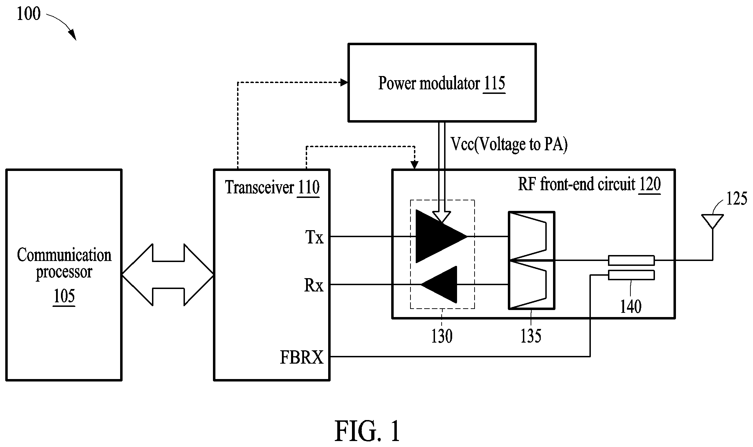

FIG. 1 is a diagram illustrating a configuration of a wireless communication device.

Referring to FIG. 1, a wireless communication device 100 may include a communication processor 105, a transceiver 110 configured to be controlled by the communication processor 105 to perform wireless communication, a radio frequency (RF) front-end circuit 120 configured to amplify an RF transmission signal and an RF reception signal, a power modulator 115 configured to supply power to an amplifier 130 of the RF front-end circuit 120, and an antenna 125 configured to transmit and receive RF signals. The RF front-end circuit 120 may include, for example, the amplifier 130, a duplexer 135, and/or a coupler 140.

The transceiver 110 may include a phase locked loop (PLL) circuit configured to generate an oscillator signal based on a clock frequency signal and an RF transmission signal generation circuit configured to generate an RF transmission signal Tx based on the oscillator signal received from the PLL circuit and a baseband transmission signal received from the communication processor 105. Such components and/or functionalities are described/illustrated in more detail below with references being made to FIG. 1 to FIG. 11.

In the wireless communication device 100, the transceiver 110 may be controlled by the communication processor 105 based on software. However, when such software-based control is performed, the transceiver 110 may operate abnormally due to a human error leading for example to a software inaccuracy. For example, if the control of the transceiver 110 is not properly performed in a case of transmitting the RF transmission signal, an RF transmission signal of a frequency that is out of a normal range may be generated. For example, there may be a case in which, before a phase of an oscillator signal is locked, the transceiver 110 may generate an RF signal using the oscillator signal, and in this case, an RF transmission signal of an unintended frequency may be generated. There may be a frequency range of an RF transmission signal that is normally amplifiable by the RF front-end circuit 120 according to circuit characteristics of the wireless communication device 100. When an RF transmission signal of an abnormal frequency that is out of such a normally amplifiable range by the RF front-end circuit 120 is amplified by the RF front-end circuit 120, this may cause damage to components included in the RF front-end circuit 120.

For example, the PLL circuit of the wireless communication device 100 may determine whether the phase of the oscillator signal is locked by comparing a clock frequency signal and the oscillator signal that is an output signal of the PLL circuit. In general, the PLL circuit may be configured to adjust the frequency of the oscillator signal to match the frequency of the clock frequency signal. In that sense, the clock frequency signal may be referred to as a reference signal having a reference frequency, for example generated by the wireless communication device 100 or received by the wireless communication device 100. The wireless communication device 100 may include a decision circuit configured to control activation (or enable) of at least one component included in the RF transmission signal generation circuit based on whether the phase of the oscillator signal is locked. The decision circuit may activate at least one component included in the RF transmission signal generation circuit when the phase of the oscillator signal is locked and may deactivate at least one component included in the RF transmission signal generation circuit when the phase of the oscillator signal is not locked. The at least one component included in the RF transmission signal generation circuit may be, for example, an active component such as an amplifier, a voltage converter, and a mixer. When the at least one component included in the RF transmission signal generation circuit is deactivated, the RF transmission signal may not be generated in the RF transmission signal generation circuit. The wireless communication device 100 may be configured to activate the RF transmission signal generation circuit only when the phase of the oscillator signal is locked, thereby preventing the generation of an RF transmission signal of an abnormal frequency that may be generated by the oscillator signal with the phase not locked.

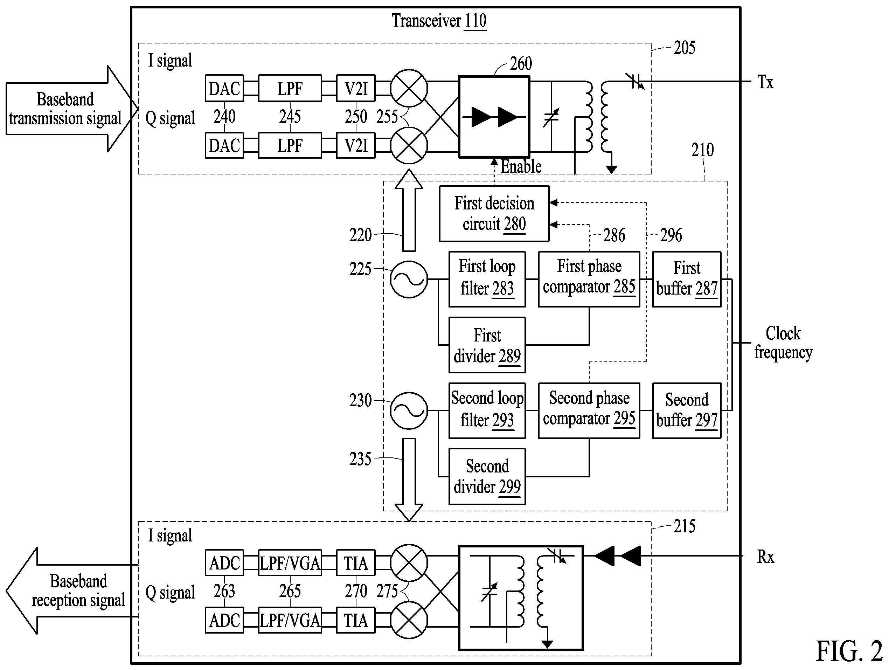

FIG. 2 is a diagram illustrating a first decision circuit configured to control activation of a RF transmission signal generation circuit. One or more of such components may be the same as and/or may be implemented together with components illustrated in and/or described with references being made to FIG. 1, 3-11.

Referring to FIG. 2, an example block diagram of the transceiver 110 is shown. The transceiver 110 of the wireless communication device 100 may include a PLL circuit 210 configured to generate an oscillator signal based on a clock frequency signal. The PLL circuit 210 may include: a first buffer 287 configured to amplify the clock frequency signal and transfer it to a first phase comparator 285; the first phase comparator 285 configured to compare phases of the clock frequency signal and a first oscillator signal 220; a first oscillator 225 configured to generate the first oscillator signal 220 based on an output signal of the first phase comparator 285; a first divider 289 configured to lower a frequency of the first oscillator signal 220 and transfer it (the first oscillator signal 220 with a lowered frequency) to the first phase comparator 285; and/or a first loop filter 283 configured to remove noise included in the output signal of the first phase comparator 285.

The PLL circuit 210 may also include : a second buffer 297 configured to amplify the clock frequency signal and transfer it to a second phase comparator 295; the second phase comparator 295 configured to compare phases of the clock frequency signal and a second oscillator signal 235; a second oscillator 230 configured to generate the second oscillator signal 235 based on an output signal of the second phase comparator 295; a second divider 299 configured to lower a frequency of the second oscillator signal 235 and transfer it to the second phase comparator 295; and/or a second loop filter 293 configured to remove noise included in the output signal of the second phase comparator 295.

The transceiver 110 may also include an RF transmission signal generation circuit 205 configured to generate an RF transmission signal Tx based on the first oscillator signal 220 received from the PLL circuit 210 and a baseband transmission signal received from the communication processor 105. The transceiver 110 may also include an RF reception signal processing circuit 215 configured to generate a baseband reception signal based on the second oscillator signal 235 received from the PLL circuit 210 and an RF reception signal Rx received from the outside.

The RF reception signal Rx received from the outside through the antenna 125 may be combined with the second oscillator signal 235 in a mixer 275. The combined signal may be converted to the baseband reception signal, passing through a transimpedance amplifier (TIA) 270, a low-pass filter (LPF)/variable gain amplifier (VGA) 265, and a voltage analog-to-digital converter (ADC) 263. The baseband reception signal may be transferred to the communication processor 105. The baseband transmission signal and the baseband reception signal may each be complex signals that may include an I signal of an in-phase component and a Q signal of a quadrature component.

The communication processor 105 may transfer, to the transceiver 110, the baseband transmission signal including data that is to be transmitted to the outside. The transmission signal generated by the communication processor 105 may be a digital signal. The baseband transmission signal input to the transceiver 110 may be converted to an analog signal through a voltage digital-to-analog converter (DAC) 240 of the RF transmission signal generation circuit 205 and be filtered to a signal of a set bandwidth through an LPF 245. The filtered signal may be combined with the first oscillator signal 220 in a mixer 255, after passing through a voltage-to-current (V2I) amplifier 250. The RF transmission signal generated as combined in the mixer 255 may be a voltage signal. The RF transmission signal may be amplified by an RF signal amplifier 260 and then be output. The RF signal amplifier 260 may include, for example, a VGA and a drive amplifier (DA).

The RF transmission signal Tx may be generated by a baseband transmission signal being combined with the first oscillator signal 220, and thus a frequency and phase of the RF transmission signal Tx may also become unstable when the frequency and phase of the first oscillator signal 220 are unstable. The wireless communication device 100 may first determine whether phases of oscillator signals output from the PLL circuit 210 are locked to stably transmit the RF transmission signal Tx, and then activate the RF transmission signal generation circuit 205 when the phases of the oscillator signals are locked.

The first phase comparator 285 in the PLL circuit 210 may compare the clock frequency signal and the first oscillator signal 220 and generate the first oscillator signal 220 indicating whether the phase of the first oscillator signal 220 is locked. The second phase comparator 295 in the PLL circuit 210 may compare the clock frequency signal and the second oscillator signal 235 and generate the second oscillator signal 235 indicating whether the phase of the second oscillator signal 235 is locked.

The transceiver 110 may also include a first decision circuit 280 configured to control activation of at least one component included in the RF transmission signal generation circuit 205 based on at least one of the first oscillator signal 220 or the second oscillator signal 235. The first decision circuit 280 may receive a first phase comparison signal 286 from the first phase comparator 285. The first decision circuit 280 may receive a second phase comparison signal 296 from the second phase comparator 295. The first decision circuit 280 may activate at least one component included in the RF transmission signal generation circuit 205 for example when both the phase of the first oscillator signal 220 and the phase of the second oscillator signal 235 are locked, and may deactivate at least one component included in the RF transmission signal generation circuit 205 when at least one of the phase of the first oscillator signal 220 or the phase of the second oscillator signal 235 is not locked, based on at least one of the first phase comparison signal 286 or the second phase comparison signal 296. When for example only the first phase comparator 285, configured to generate the first oscillator signal 220, is implemented, then the first decision circuit 280 may activate at least one component included in the RF transmission signal generation circuit 205 when the phase of the first oscillator signal 220 is locked. Similarly for the case when only the second phase comparator 295 is implemented.

In a wireless communication operation, when transmitting an RF transmission signal using a communication network, the wireless communication device 100 may need to receive a signal for establishing a communication channel with a base station, and the phase of the second oscillator signal 235 supplied to the RF reception signal processing circuit 215 may need to be locked prior to the phase of the first oscillator signal 220 supplied to the RF transmission signal generation circuit 205 in order to receive the corresponding signal. In this case, an RF transmission signal that is generated without the phase of the second oscillator signal 235 being locked may be an unnecessary signal. For example, to stably generate an RF transmission signal, the wireless communication device 100 may control the activation of the RF transmission signal generation circuit 205 in consideration of both whether the phase of the second oscillator signal 235 is locked and whether the phase of the first oscillator signal 220 is locked.

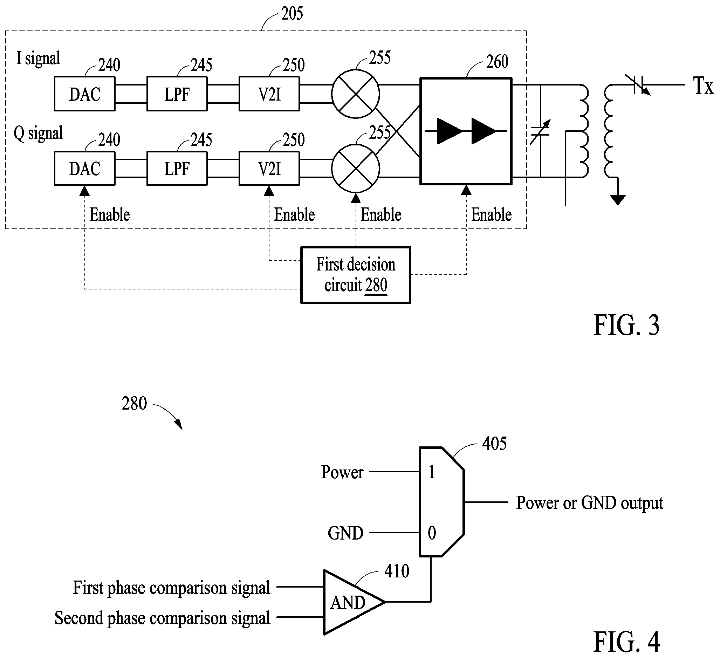

FIG. 3 is a diagram illustrating components of an RF transmission signal generation circuit for which a first decision circuit controls activation and/or deactivation. One or more of such components may be the same as and/or may be implemented together with components illustrated in and/or described with references being made to FIG. 1, 2, 4-11.

Referring to FIG. 3, components of the RF transmission signal generation circuit 205 that may be controlled by the first decision circuit 280 are shown.

The first decision circuit 280 may activate at least one component included in the RF transmission signal generation circuit 205 based on, for example, a first phase comparison signal 286 and a second phase comparison signal 296. The component controlled by the first decision circuit 280 may be, for example, an active component included in an RF transmission circuit. For example, the first decision circuit 280 may control activation of one or more of an amplifier, a voltage converter, and a mixer, e.g., based on the first phase comparison signal 286 and the second phase comparison signal 296.

For example, the first decision circuit 280 may activate at least one component included in the RF transmission signal generation circuit 205 when a phase of a first oscillator signal 220 and a phase of a second oscillator signal 235 are both locked. According to another example, the first decision circuit 280 may deactivate at least one component included in the RF transmission signal generation circuit 205 when the phase of the first oscillator signal 220 and the phase of the second oscillator signal 235 are not locked. According to another example, the first decision circuit 280 may deactivate at least one component included in the RF transmission signal generation circuit 205 when at least one of the phase of the first oscillator signal 220 and the phase of the second oscillator signal 235 is not locked.

When the at least one component included in the RF transmission signal generation circuit 205 is deactivated, an RF transmission signal may not be generated in the RF transmission signal generation circuit 205. When at least one of the phases of the first oscillator signal 220 and the second oscillator signal 235 is not locked, the first decision circuit 280 may deactivate the RF transmission signal generation circuit 205, thereby preventing the generation of an RF transmission signal of an abnormal frequency that may be generated by an oscillator signal of which a phase is not locked.

The first decision circuit 280 may control the at least one component of the RF transmission signal generation circuit 205 for example by controlling power to be supplied to the at least one component or controlling a bias voltage or bias current to be supplied to the at least one component.

FIG. 4 is a diagram illustrating an input and output of a first decision circuit. One or more of components illustrated in and/or described with reference to FIG. 4 may be the same as and/or may be implemented together with components illustrated in and/or described with references being made to FIG. 1-3, 5-11.

Referring to FIG. 4, an example logic circuit of the first decision circuit 280 is shown.

As an example, one or more of power, ground (or GND), a first phase comparison signal 286, and a second phase comparison signal 296 may be input to the first decision circuit 280. For example, the logic circuit of the first decision circuit 280 may include a multiplexer 405 to which the power and the ground are input and an AND gate 410 to which the first phase comparison signal 286 and the second phase comparison signal 296 are input.

The first decision circuit 280 may output the input power or ground based on at least one of the first phase comparison signal 286 and the second phase comparison signal 296. The output of the first decision circuit 280 may be connected to at least one component of the RF transmission signal generation circuit 205 to activate or deactivate the respective component.

The first decision circuit 280 may activate at least one component included in the RF transmission signal generation circuit 205 when a phase of a first oscillator signal 220 and a phase of a second oscillator signal 235 are locked, and may deactivate at least one component included in the RF transmission signal generation circuit 205 when at least one of the phase of the first oscillator signal 220 or the phase of the second oscillator signal 235 is not locked.

For example, the first phase comparator 285 of the PLL circuit 210 may output the first phase comparison signal 286 of a first value when a phase difference between a clock frequency signal and the first oscillator signal 220 is maintained within a set range for a set time, and may output the first phase comparison signal 286 of a second value when the phase difference between the clock frequency signal and the first oscillator signal 220 is not maintained within the set range for the set time. A phase comparison signal of a certain value may mean that the phase comparison signal corresponds to the certain value, or can be measured and/or identified with the certain value. The second phase comparator 295 of the PLL circuit 210 may output the second phase comparison signal 296 of a first value when a phase difference between the clock frequency signal and the second oscillator signal 235 is maintained within a set range for a set time, and may output the second phase comparison signal 296 of a second value when the phase difference between the clock frequency signal and the second oscillator signal 235 is not maintained within the set range for the set time. Each of the set range and set time may be configured differently for each of the first and second phase comparator, respectively, or may be configured similarly or the same. Each may be pre-set, configurable, and/or pre-determined. The set range may refer to an interval or a set range of values for the phase difference. The set time may refer to a time interval with a pre-determined, pre-set, and/or configurable length. For convenience of description, the expressions "set range", "set time" etc. are used herein below.

A phase comparator (e.g., the first phase comparator 285 and/or the second phase comparator 295) may include either an analog circuit or a digital circuit. For example, if the phase comparator includes the analog circuit, a phase difference between a clock frequency signal and an oscillator signal (e.g., the first oscillator signal 220 or the second oscillator signal 235) may be represented as an analog voltage. In this case, when the analog voltage indicating the phase difference is maintained within a set voltage range for a set time, the phase comparator may determine that a phase of the oscillator signal is locked and can generate a phase comparison signal (e.g., the first phase comparison signal 286 or the second phase comparison signal 296) of a first value. For another example, if the phase comparator is the digital circuit, the phase difference between the clock frequency signal and the oscillator signal (e.g., the first oscillator signal 220 or the second oscillator signal 235) may be represented as a digital bit. In this case, when a value of the digital bit is maintained within a set value range for a set time, the phase comparator may determine that a phase of the oscillator signal is locked and generate a phase comparison signal of a first value.

For example, the first decision circuit 280 may output the input power when a value of the first phase comparison signal 286 is the first value and a value of the second phase comparison signal 296 is the first value, and may output the input ground when at least one of the value of the first phase comparison signal 286 or the value of the second phase comparison signal 296 is the second value.

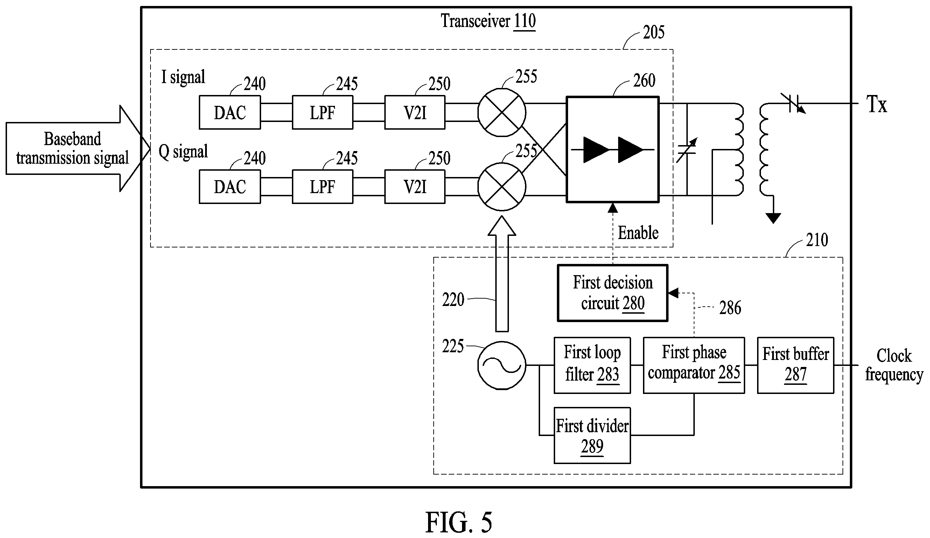

FIG. 5 is a diagram illustrating a first decision circuit. One or more of components illustrated in and/or described with reference to FIG. 5 may be the same as and/or may be implemented together with components illustrated in and/or described with references being made to FIG. 1-4, 6-11.

In terms of circuit design, it may be difficult to include (or add) a wiring line that transfers a second phase comparison signal 296 to the first decision circuit 280 into a circuit of the transceiver 110 as shown in FIG. 2. Referring to FIG. 5, an example of the first decision circuit 280 configured to control activation of the RF transmission signal generation circuit 205 based on a first phase comparison signal 286 is shown.

The first phase comparator 285 in the PLL circuit 210 may compare a clock frequency signal and a first oscillator signal 220 to generate the first oscillator signal 220 indicating whether a phase of the first oscillator signal 220 is locked. The transceiver 110 may include the first decision circuit 280 configured to control activation of at least one component included in the RF transmission signal generation circuit 205 based on the first oscillator signal 220. For example, the first decision circuit 280 may receive the first phase comparison signal 286 from the first phase comparator 285. The first decision circuit 280 may activate at least one component included in the RF transmission signal generation circuit 205 when the phase of the first oscillator signal 220 is locked, and may deactivate at least one component included in the RF transmission signal generation circuit 205 when the phase of the first oscillator signal 220 is not locked, based on the first phase comparison signal 286. Substantially the same description of the first decision circuit 280 provided above with reference to FIG. 3 may apply to the description of components of the RF transmission signal generation circuit 205 to be controlled by the first decision circuit 280.

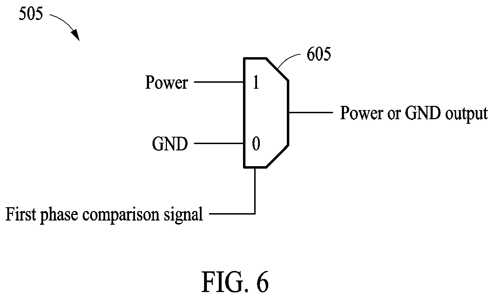

FIG. 6 is a diagram illustrating an input and output of a first decision circuit. One or more of components illustrated in and/or described with reference to FIG. 6 may be the same as and/or may be implemented together with components illustrated in and/or described with references being made to FIG. 1-5, 7-11.

Referring to FIG. 6, an example logic circuit of a first decision circuit 505 (e.g., the first decision circuit 280 of FIGS. 2 and 5) is shown.

As an example, one or more of power, ground (or GND), and a first phase comparison signal 286 may be input to the first decision circuit 505. For example, the logic circuit of the first decision circuit 505 may include a multiplexer 605 to which the power and the ground are input.

The first decision circuit 505 may output the input power or ground based on the first phase comparison signal 286. The output of the first decision circuit 505 may be connected to at least one component of the RF transmission signal generation circuit 205 to activate or deactivate the respective component.

The first decision circuit 505 may activate at least one component included in the RF transmission signal generation circuit 205 when a phase of a first oscillator signal 220 is locked, and may deactivate at least one component included in the RF transmission signal generation circuit 205 when the phase of the first oscillator signal 220 is not locked.

For example, the first phase comparator 285 of the PLL circuit 210 may output the first phase comparison signal 286 of a first value when a phase difference between a clock frequency signal and the first oscillator signal 220 is maintained within a set range for a set time, and may output the first phase comparison signal 286 of a second value when the phase difference between the clock frequency signal and the first oscillator signal 220 is not maintained within the set range for the set time.

For example, the first decision circuit 505 may output the input power when a value of the first phase comparison signal 286 is the first value, and may output the input ground when the value of the first phase comparison signal 286 is the second value.

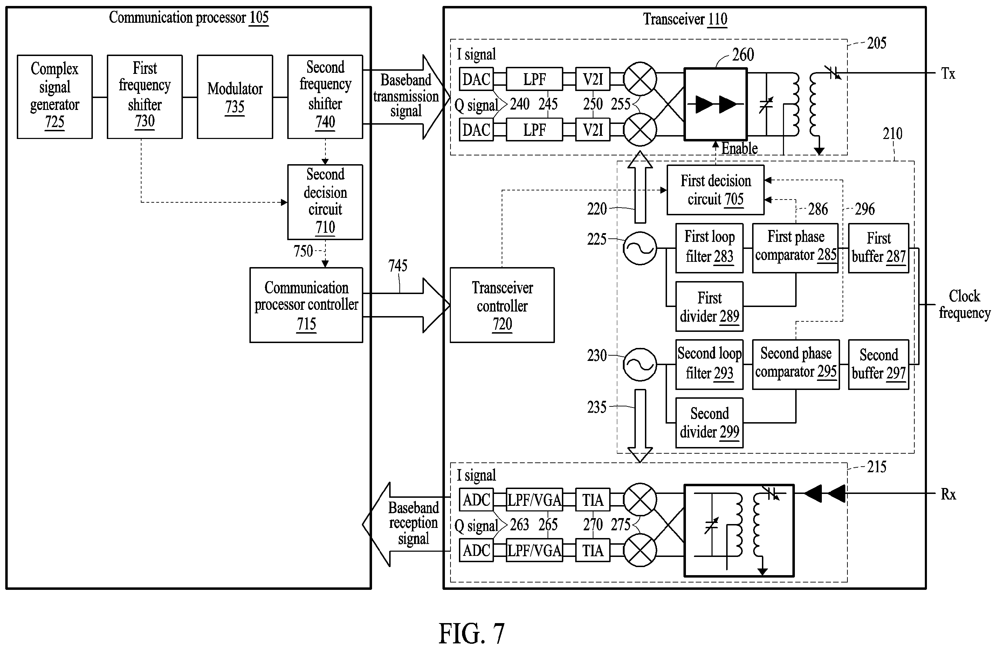

FIG. 7 is a diagram illustrating a first decision circuit and a second decision circuit.

Referring to FIG. 7, examples of the communication processor 105 and the transceiver 110 are shown in a block diagram. One or more of components illustrated in and/or described with reference to FIG. 7 may be the same as and/or may be implemented together with components illustrated in and/or described with references being made to FIG. 1-6, 8-11.

The transceiver 110 may include a first decision circuit 705 configured to control activation of an RF transmission signal generation circuit 205 based on a first phase comparison signal 286 received from a first phase comparator 285, a second phase comparison signal 296 received from a second phase comparator 295, and a signal received from a second decision circuit 710.

The communication processor 105 may include at least one of a complex signal generator 725 configured to generate a complex signal, a first frequency shifter 730 configured to shift a frequency of the complex signal to generate a baseband transmission signal, a modulator 735 configured to modulate the complex signal, a second frequency shifter 740 configured to shift a frequency of a complex signal modulated by the modulator 735 to generate the baseband transmission signal, and/or the second decision circuit 710 configured to detect whether the first frequency shifter 730 operates and whether the second frequency shifter 740 operates, and transfer a detection result signal 750 to the first decision circuit 705.

The communication processor 105 may generate the baseband transmission signal from the complex signal using any one of the first frequency shifter 730 and the second frequency shifter 740. The communication processor 105 may select a frequency resource block to be used for RF signal transmission, using a frequency shifter (e.g., the first frequency shifter 730 and the second frequency shifter 740). The communication processor 105 may use one of the first frequency shifter 730 and the second frequency shifter 740 according to a communication protocol used for transmission of an RF transmission signal. For example, when transmitting a physical random-access channel (PRACH) protocol signal, the communication processor 105 may generate the baseband transmission signal using a complex signal of a Zadoff-chu sequence and the first frequency shifter 730. When transmitting data such as a physical uplink shared channel (PUSCH), the communication processor 105 may generate the baseband transmission signal using the modulator 735 and the second frequency shifter 740.

As described above, one of the first frequency shifter 730 and the second frequency shifter 740 may be used as needed. However, when both the first frequency shifter 730 and the second frequency shifter 740 are used, a frequency of the baseband transmission signal may be changed to an unintended frequency.

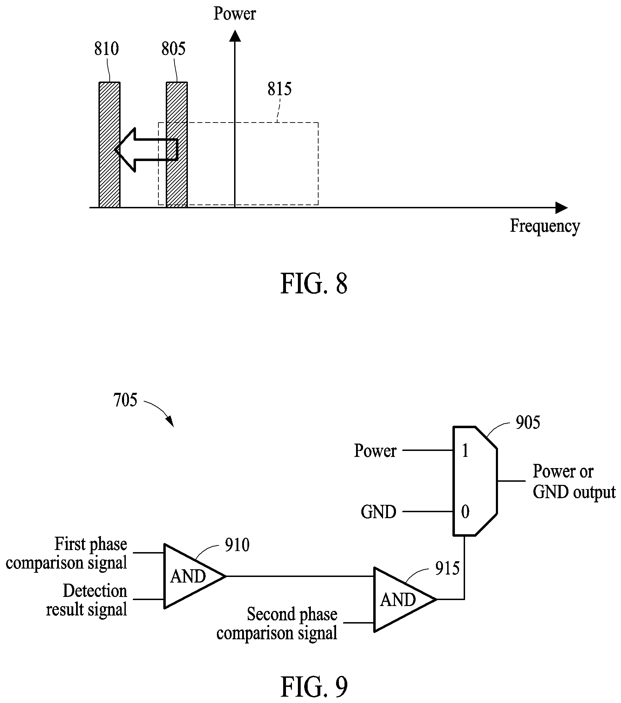

For example, referring to FIG. 8, an example case in which a baseband signal frequency is out of a normal range by the first frequency shifter 730 and the second frequency shifter 740 is shown.

For example, when the communication processor 105 generates a baseband transmission signal using the first frequency shifter 730, the generated baseband transmission signal may be a first-frequency baseband transmission signal 805. When both the first frequency shifter 730 and the second frequency shifter 740 operate to generate a baseband transmission signal, the generated baseband transmission signal may be a second-frequency baseband transmission signal 810. In this example, a second frequency may be a frequency that is out of a normal frequency range 815 according to a circuit design of a wireless communication device, and a baseband transmission signal of this frequency may damage the RF front-end circuit 120 during signal processing.

The second decision circuit 710 may detect whether the first frequency shifter 730 and the second frequency shifter 740 operate or not, and may transfer a detection result signal 750 to the first decision circuit 705. For example, the detection result signal 750 may be converted to a digital signal in a communication processor controller 715 that controls the operations performed by the communication processor 105, and the digital signal may be transferred to a transceiver controller 720 through a digital interface 745 connecting the communication processor 105 and the transceiver 110. The transferred signal may be transferred to the first decision circuit 705 through the transceiver controller 720 that controls the operations performed by the transceiver 110. The detection result signal 750 may also be transferred to the first decision circuit 705 through a dedicated interface for transmitting the detection result signal 750 that is formed separately from the digital interface 745.

The first decision circuit 705 may control activation of at least one component of the RF transmission signal generation circuit 205 based on the detection result signal 750 received from the second decision circuit 710, the first phase comparison signal 286, and the second phase comparison signal 296. As the first decision circuit 705 controls the activation of at least one component of the RF transmission signal generation circuit 205, further using a result of the detection of the second decision circuit 710, in addition to the first phase comparison signal 286 and the second phase comparison signal 296, it may prevent damage that may be caused by a baseband transmission signal out of a normal frequency range. Substantially the same description of the first decision circuit 280 provided above with reference to FIG. 3 may apply to the description of components of the RF transmission signal generation circuit 205 to be controlled by the first decision circuit 705.

When any one of the first frequency shifter 730 and the second frequency shifter 740 operates and the phase of the first oscillator signal 220 and the phase of the second oscillator signal 235 are locked, based on the detection result signal 750, the first phase comparison signal 286, and the second phase comparison signal 296, the first decision circuit 705 may activate at least one component included in the RF transmission signal generation circuit 205. When the first frequency shifter 730 and the second frequency shifter 740 both operate, or at least one of the phase of the first oscillator signal 220 or the phase of the second oscillator signal 235 is not locked, based on the detection result signal 750, the first phase comparison signal 286, and the second phase comparison signal 296, the first decision circuit 705 may deactivate at least one component included in the RF transmission signal generation circuit 205.

FIG. 9 is a diagram illustrating an input and output of a first decision circuit. One or more of components illustrated in and/or described with reference to FIG. 9 may be the same as and/or may be implemented together with components illustrated in and/or described with references being made to FIG. 1-8, 10, 11.

Referring to Fig. 9, an example logic circuit of a first decision circuit is shown.

For example, power, ground (or GND), a first phase comparison signal 286, a second phase comparison signal 296, and a detection result signal 750 transferred from the second decision circuit 710 may be input to the first decision circuit 705. For example, the logic circuit of the first decision circuit 705 may include a multiplexer 905 to which the power and the ground are input, a first AND gate 910 to which the first phase comparison signal 286 and the detection result signal 750 are input, and a second AND gate 915 to which the second phase comparison signal 296 and an output of the first AND gate 910 are input.

The first decision circuit 705 may output the input power or ground based on the detection result signal 750, the first phase comparison signal 286, and the second phase comparison signal 296. The output of the first decision circuit 705 may be connected to at least one component of the RF transmission signal generation circuit 205 to activate or deactivate the respective component.

When any one of the first frequency shifter 730 and the second frequency shifter 740 operates, and a phase of a first oscillator signal 220 and a phase of a second oscillator signal 235 are locked, the first decision circuit 705 may activate at least one component included in the RF transmission signal generation circuit 205. When the first frequency shifter 730 and the second frequency shifter 740 operate simultaneously, or at least one of the phase of the first oscillator signal 220 or the phase of the second oscillator signal 235 is not locked, the first decision circuit 705 may deactivate at least one component included in the RF transmission signal generation circuit 205.

For example, the first phase comparator 285 of the PLL circuit 210 may output the first phase comparison signal 286 of a first value when a phase difference between a clock frequency signal and the first oscillator signal 220 is maintained within a set range for a set time, and may output the first phase comparison signal 286 of a second value when the phase difference between the clock frequency signal and the first oscillator signal 220 is maintained within the set range for the set time. The second phase comparator 295 of the PLL circuit 210 may output the second phase comparison signal 296 of a first value when a phase difference between the clock frequency signal and a second oscillator signal 235 is maintained within a set range for a set time, and may output the second phase comparison signal 296 of a second value when the phase difference between the clock frequency signal and the second oscillator signal 235 is not maintained within the set range for the set time. The second decision circuit 710 may output the detection result signal 750 of a first value when any one of the first frequency shifter 730 and the second frequency shifter 740 operates, and may output the detection result signal 750 of a second value when the first frequency shifter 730 and the second frequency shifter 740 operate.

For example, the first decision circuit 705 may output the input power when a value of the detection result signal 750 is the first value, a value of the first phase comparison signal 286 is the first value, and a value of the second phase comparison signal 296 is the first value, and may output the input ground when at least one of the value of the detection result signal 750, the value of the first phase comparison signal 286, or the value of the second phase comparison signal 296 is the second value.

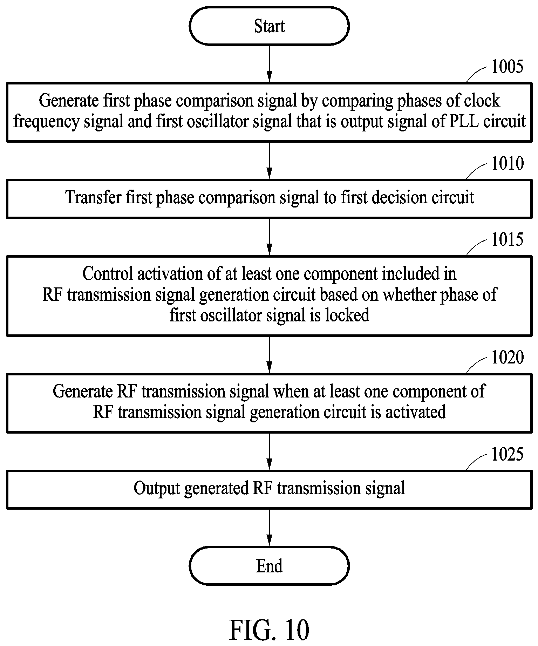

FIG. 10 is a flowchart illustrating a method of controlling activation of an RF transmission signal generation circuit. One or more of components illustrated in and/or described with reference to FIG. 10 may be the same as and/or may be implemented together with components illustrated in and/or described with references being made to FIG. 1-9, 11.

Referring to FIG. 10, in operation 1005, the first phase comparator 285 may generate a first phase comparison signal 286 indicating whether a phase of a first oscillator signal 220 is locked by comparing a phase of a clock frequency signal and the phase of the first oscillator signal 220 that is an output signal of the PLL circuit 210.

For example, the first phase comparator 285 may generate the first oscillator signal 220 of a first value when a value of the first phase comparison signal 286 is maintained within a set range for a set time, and may generate the first oscillator signal 220 of a second value when the value of the first phase comparison signal 286 is not maintained within the set range for the set time.

An oscillator (e.g., the first oscillator 225 or the second oscillator 230) of the PLL circuit 210 may generate an oscillator signal (e.g., the first oscillator signal 220 or the second oscillator signal 235) based on an output signal of a phase comparator (e.g., the first phase comparator 285 or the second phase comparator 295). A divider (e.g., the first divider 289 or the second divider 299) of the PLL circuit 210 may lower a frequency of the oscillator signal (e.g., the first oscillator signal 220 or the second oscillator signal 235) and may transfer it to the phase comparator (e.g., the first phase comparator 285 or the second phase comparator 295). A loop filter (e.g., the first loop filter 283 or the second loop filter 293) of the PLL circuit 210 may remove noise included in an output signal of the phase comparator (e.g., the first phase comparator 285).

In operation 1010, the first phase comparator 285 may transfer the generated first phase comparison signal 286 to a first decision circuit (e.g., the first decision circuit 280, the first decision circuit 505, or the first decision circuit 705).

In operation 1015, the first decision circuit (e.g., the first decision circuit 280) may control activation of at least one component included in the RF transmission signal generation circuit 205, based on whether the phase of the first oscillator signal 220 indicated in the first phase comparison signal 286 is locked.

For example, the first decision circuit (e.g., the first decision circuit 280) may activate at least one component included in the RF transmission signal generation circuit 205 when the phase of the first oscillator signal 220 is locked, and may deactivate at least one component included in the RF transmission signal generation circuit 205 when the phase of the first oscillator signal 220 is not locked. The at least one component of the RF transmission signal generation circuit 205 for which the activation may be controlled by the first decision circuit (e.g., the first decision circuit 280) may be an active component. For example, the first decision circuit (e.g., the first decision circuit 280) may activate at least one of an amplifier, a voltage converter, or a mixer included in the RF transmission signal generation circuit 205 when the phase of the first oscillator signal 220 is locked, and may deactivate at least one of the amplifier, the voltage converter, or the mixer included in the RF transmission signal generation circuit 205 when the phase of the first oscillator signal 220 is not locked.

The second phase comparator 295 in the PLL circuit 210 may generate a second phase comparison signal 296 indicating whether a phase of a second oscillator signal 235 is locked by comparing the phase of the clock frequency signal and the phase of the second oscillator signal 235 that is an output signal of the PLL circuit 210, and may transfer the second phase comparison signal 296 to the first decision circuit (e.g., the first decision circuit 505) of the transceiver 110.

The first decision circuit (e.g., the first decision circuit 505) may activate at least one component included in the RF transmission signal generation circuit 205 when the phase of the first oscillator signal 220 is locked and the phase of the second oscillator signal 235 indicated in the second phase comparison signal 296 is locked, and may deactivate at least one component included in the RF transmission signal generation circuit 205 when at least one of the phase of the first oscillator signal 220 or the phase of the second oscillator signal 235 is not locked.

The second decision circuit 710 included in the communication processor 105 may detect whether the first frequency shifter 730, which is configured to shift a frequency of a complex signal generated in the communication processor 105 to generate a baseband transmission signal, operates and detect whether the second frequency shifter 740, which is configured to shift a frequency of a complex signal modulated in the communication processor 105 to generate the baseband transmission signal, operates. The second decision circuit 710 may transfer, to the first decision circuit (e.g., the first decision circuit 705), a detection result signal indicating a result of detecting whether the first frequency shifter 730 and/or the second frequency shifter 740 operate. The detection result signal may be transferred through a digital interface between the communication processor 105 and the transceiver 110.

The first decision circuit (e.g., the first decision circuit 705) may activate at least one component included in the RF transmission signal generation circuit 205 when any one of the first frequency shifter 730 and the second frequency shifter 740 is detected to operate, and the phase of the first oscillator signal 220 and the phase of the second oscillator signal 235 are locked, based on the detection result signal, the first phase comparison signal 286, and the second phase comparison signal 296. The first decision circuit (e.g., the first decision circuit 705) may deactivate at least one component included in the RF transmission signal generation circuit 205 when the first frequency shifter 730 and the second frequency shifter 740 operate, or the phase of the first oscillator signal 220 is not locked or the phase of the second oscillator signal 235 is not locked, based on the detection result signal, the first phase comparison signal 286, and the second phase comparison signal 296.

The first decision circuit (e.g., the first decision circuit 705) may control the activation of the at least one component by controlling power to be supplied to the at least one component of the RF transmission signal generation circuit 205 or controlling a bias voltage or bias current of the at least one component.

In operation 1020, when the at least one component of the RF transmission signal generation circuit 205 is activated in operation 1015, the RF transmission signal generation circuit 205 may generate an RF transmission signal from the first oscillator signal 220 and the baseband transmission signal generated by the communication processor 105 of the wireless communication device 100. In operation 1025, the RF transmission signal generation circuit 205 may output the generated RF transmission signal.

A wireless communication device 100 may include a communication processor 105 and a transceiver 110 controlled by the communication processor 105 to perform wireless communication. The transceiver 110 may include at least one of: a PLL circuit 210 configured to generate a first oscillator signal 220 based on a clock frequency signal; an RF transmission signal generation circuit 205 configured to generate an RF transmission signal based on the first oscillator signal 220 received from the PLL circuit 210 and a baseband transmission signal received from the communication processor 105; and a first decision circuit (e.g., a first decision circuit 280) configured to receive a first phase comparison signal 286 indicating whether a phase of the first oscillator signal 220 is locked from a first phase comparator 285 in the PLL circuit 210, and control activation of at least one component included in the RF transmission signal generation circuit 205 based on the first phase comparison signal 286.

The first phase comparator 285 may compare a phase of the clock frequency signal and the phase of the first oscillator signal 220 which is an output signal of the PLL circuit 210 to generate the first phase comparison signal 286 indicating whether the phase of the first oscillator signal 220 is locked.

For example, the first phase comparator 285 may generate the first oscillator signal 220 of a first value when a value of the first phase comparison signal 286 is maintained within a set range for a set time, and may generate the generate the first oscillator signal 220 of a second value when the value of the first phase comparison signal 286 is not maintained within the set range for the set time.

An oscillator (e.g., a first oscillator 225 or a second oscillator 230) of the PLL circuit 210 may generate an oscillator signal (e.g., the first oscillator signal 220 or a second oscillator signal 235) based on an output signal of a phase comparator (e.g., the first phase comparator 285 or the second phase comparator 295). A divider (e.g., a first divider 289 or a second divider 299) of the PLL circuit 210 may lower a frequency of the oscillator signal (e.g., the first oscillator signal 220 or the second oscillator signal 235) and transfer it to the phase comparator (e.g., the first phase comparator 285 or the second phase comparator 295). A loop filter (e.g., a first loop filter 283 or a second loop filter 293) of the PLL circuit 210 may remove noise included in an output signal of the phase comparator (e.g., the first phase comparator 285).

The first phase comparator 285 may transfer the generated first phase comparison signal 286 to the first decision circuit (e.g., the first decision circuit 280, a first decision circuit 505, or a first decision circuit 705).

The first decision circuit (e.g., the first decision circuit 280) may control activation of at least one component included in the RF transmission signal generation circuit 205 based on whether the phase of the first oscillator signal 220 indicated in the first phase comparison signal 286 is locked.

For example, the first decision circuit (e.g., the first decision circuit 280) may activate at least one component included in the RF transmission signal generation circuit 205 when the phase of the first oscillator signal 220 is locked, and may deactivate at least one component included in the RF transmission signal generation circuit 205 when the phase of the first oscillator signal 220 is not locked. The at least one component of the RF transmission signal generation circuit 205 for which the activation may be controlled by the first decision circuit (e.g., the first decision circuit 280) may be an active component. For example, the first decision circuit (e.g., the first decision circuit 280) may activate at least one of an amplifier, a voltage converter, or a mixer included in the RF transmission signal generation circuit 205 when the phase of the first oscillator signal 220 is locked, and may deactivate at least one of the amplifier, the voltage converter, or the mixer included in the RF transmission signal generation circuit 205 when the phase of the first oscillator signal 220 is not locked.

A second phase comparator 295 in the PLL circuit 210 may compare the phase of the clock frequency signal and a phase of a second oscillator signal 235 which is an output signal of the PLL circuit 210 to generate a second phase comparison signal 296 indicating whether the phase of the second oscillator signal 235 is locked, and may transfer the second phase comparison signal 296 to the first decision circuit (e.g., the first decision circuit 505) of the transceiver 110.

The first decision circuit (e.g., the first decision circuit 505) may activate at least one component included in the RF transmission signal generation circuit 205 when the phase of the first oscillator signal 220 is locked and the phase of the second oscillator signal 235 indicated in the second phase comparison signal 296 is locked, and may deactivate at least one component included in the RF transmission signal generation circuit 205 when at least one of the phase of the first oscillator signal 220 or the phase of the second oscillator signal 235 is not locked.

A second decision circuit 710 included in the communication processor 105 may detect whether a first frequency shifter 730, which is configured to shift a frequency of a complex signal generated in the communication processor 105 to generate a baseband transmission signal, operates, and may detect whether a second frequency shifter 740, which is configured to shift a frequency of a complex signal modulated in the communication processor 105 to generate the baseband transmission signal, operates. The second decision circuit 710 may transfer a detection result signal indicating a result of detecting whether the first frequency shifter 730 and the second frequency shifter 740 operate to the first decision circuit (e.g., the first decision circuit 705). The detection result signal may be transferred through a digital interface between the communication processor 105 and the transceiver 110.

The first decision circuit (e.g., the first decision circuit 705) may activate at least one component included in the RF transmission signal generation circuit 205 when any one of the first frequency shifter 730 and the second frequency shifter 730 is detected to operate, and the phase of the first oscillator signal 220 and the phase of the second oscillator signal 235 are locked, based on the detection result signal, the first phase comparison signal 286, and the second phase comparison signal 296. The first decision circuit (e.g., the first decision circuit 705) may deactivate at least one component included in the RF transmission signal generation circuit 205 when the first frequency shifter 730 and the second frequency shifter 740 operate, the phase of the first oscillator signal 220 is not locked, or the phase of the second oscillator signal 220 is not locked, based on the detection result signal, the first phase comparison signal 286, and the second phase comparison signal 296.

The first decision circuit (e.g., the first decision circuit 705) may control the activation of the at least one component of the RF transmission signal generation circuit 205 by controlling power to be supplied to the at least one component or controlling a bias voltage or bias current of the at least one component.

When the at least one component of the RF transmission signal generation circuit 205 is activated, the RF transmission signal generation circuit 205 may generate an RF transmission signal from the first oscillator signal 220 and the baseband transmission signal generated by the communication processor 105 of the wireless communication device 100. The RF transmission signal generation circuit 205 may then output the generated RF transmission signal in operation 1025.

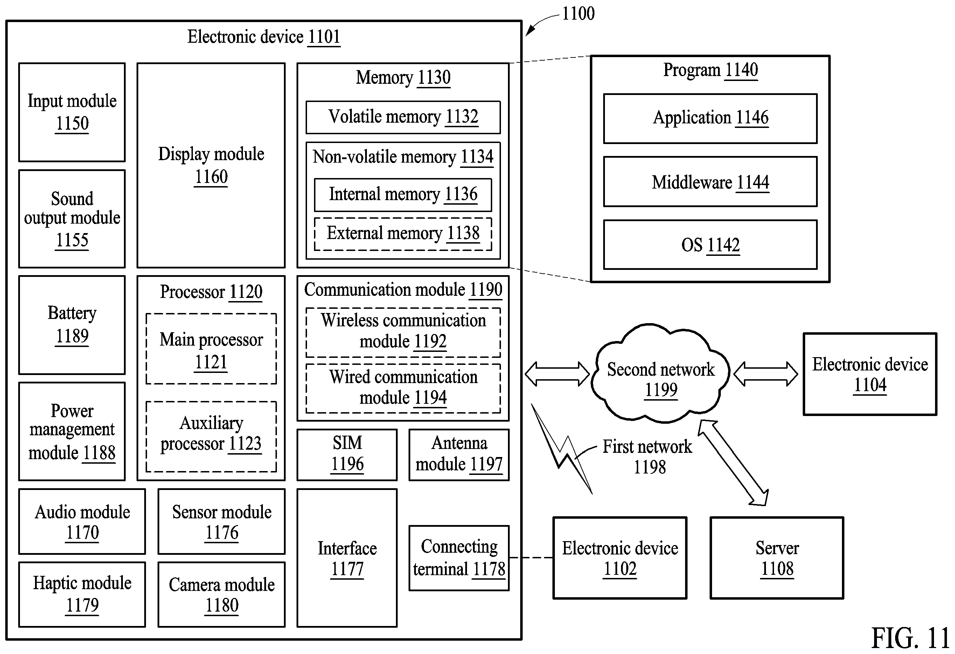

FIG. 11 is a block diagram illustrating an example electronic device including a wireless communication device. One or more of components illustrated in and/or described with reference to FIG. 11 may be the same as and/or may be the same as or may be implemented together with components illustrated in and/or described with references being made to FIG. 1-10.

Referring to FIG. 11, an electronic device 1101 in a network environment 1100 may communicate with an electronic device 1102 via a first network 1198 (e.g., a short-range wireless communication network), or communicate with at least one of an electronic device 1104 and a server 1108 via a second network 1199 (e.g., a long-range wireless communication network). According to an embodiment, the electronic device 1101 may communicate with the electronic device 1104 via the server 1108. According to an embodiment, the electronic device 1101 may include a processor 1120, a memory 1130, an input module 1150, a sound output module 1155, a display module 1160, an audio module 1170, and a sensor module 1176, an interface 1177, a connecting terminal 1178, a haptic module 1179, a camera module 1180, a power management module 1188, a battery 1189, a communication module 1190, a subscriber identification module (SIM) 1196, or an antenna module 1197. In various embodiments, at least one (e.g., the connecting terminal 1178) of the above components may be omitted from the electronic device 1101, or one or more other components may be added to the electronic device 1101. In various embodiments, some (e.g., the sensor module 1176, the camera module 1180, or the antenna module 1197) of the components may be integrated as a single component (e.g., the display module 1160).

The processor 1120 may execute, for example, software (e.g., a program 1140) to control at least one other component (e.g., a hardware or software component) of the electronic device 1101 connected to the processor 1120 and may perform various data processing or computations. According to an embodiment, as at least a part of data processing or computations, the processor 1120 may store a command or data received from another component (e.g., the sensor module 1176 or the communication module 1190) in a volatile memory 1132, process the command or data stored in the volatile memory 1132, and store resulting data in a non-volatile memory 1134. According to an embodiment, the processor 1120 may include a main processor 1121 (e.g., a central processing unit (CPU) or an application processor (AP)) or an auxiliary processor 1123 (e.g., a graphics processing unit (GPU), a neural processing unit (NPU), an image signal processor (ISP), a sensor hub processor, or a communication processor (CP)) that is operable independently from or in conjunction with, the main processor 1121. For example, when the electronic device 1101 includes the main processor 1121 and the auxiliary processor 1123, the auxiliary processor 1123 may be adapted to consume less power than the main processor 1121 or to be specific to a specified function. The auxiliary processor 1123 may be implemented separately from the main processor 1121 or as a part of the main processor 1121.

The auxiliary processor 1123 may control at least some of functions or states related to at least one (e.g., the display device 1160, the sensor module 1176, or the communication module 1190) of the components of the electronic device 1101, instead of the main processor 1121 while the main processor 1121 is in an inactive (e.g., sleep) state or along with the main processor 1121 while the main processor 1121 is an active state (e.g., executing an application). According to an embodiment, the auxiliary processor 1123 (e.g., an ISP or a CP) may be implemented as a portion of another component (e.g., the camera module 1180 or the communication module 1190) that is functionally related to the auxiliary processor 1123. According to an embodiment, the auxiliary processor 1123 (e.g., an NPU) may include a hardware structure specifically for artificial intelligence (AI) model processing. An AI model may be generated by machine learning. The machine learning may be performed by, for example, the electronic device 1101, in which the AI model is performed, or performed via a separate server (e.g., the server 1108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), and a bidirectional recurrent deep neural network (BRDNN), a deep Q-network, or a combination of two or more thereof, but is not limited thereto. The AI model may alternatively or additionally include a software structure other than the hardware structure.

The memory 1130 may store various pieces of data used by at least one component (e.g., the processor 1120 or the sensor module 1176) of the electronic device 1101. The various pieces of data may include, for example, software (e.g., the program 1140) and input data or output data for a command related thereto. The memory 1130 may include the volatile memory 1132 or the non-volatile memory 1134. The non-volatile memory 1134 may include an internal memory 1136 and/or an external memory 1138.

The program 1140 may be stored as software in the memory 1130 and may include, for example, an operating system (OS) 1142, middleware 1144, or an application 1146.

The input module 1150 may receive, from outside (e.g., a user) the electronic device 1101, a command or data to be used by another component (e.g., the processor 1120) of the electronic device 1101. The input module 1150 may include, for example, a microphone, a mouse, a keyboard, a key (e.g., a button), or a digital pen (e.g., a stylus pen).

The sound output module 1155 may output a sound signal to the outside of the electronic device 1101. The sound output module 1155 may include, for example, a speaker or a receiver. The speaker may be used for general purposes, such as playing multimedia or playing a recording. The receiver may be used to receive an incoming call. According to an embodiment, the receiver may be implemented separately from the speaker or as a part of the speaker.

The display module 1160 may visually provide information to the outside (e.g., a user) of the electronic device 1101. The display module 1160 may include, for example, a display, a hologram device, or a projector, and a control circuitry for controlling a corresponding one of the display, the hologram device, and the projector. According to an embodiment, the display module 1160 may include a touch sensor adapted to sense a touch, or a pressure sensor adapted to measure an intensity of a force of the touch.

The audio module 1170 may convert sound into an electric signal or vice versa. According to an embodiment, the audio module 1170 may obtain the sound via the input module 1150 or output the sound via the sound output module 1155 or an external electronic device (e.g., the electronic device 1102, such as a speaker or headphones) directly or wirelessly connected to the electronic device 1101.

The sensor module 1176 may detect an operational state (e.g., power or temperature) of the electronic device 1101 or an environmental state (e.g., a state of a user) external to the electronic device 1101 and generate an electric signal or data value corresponding to the detected state. According to an embodiment, the sensor module 1176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, an illuminance sensor, or a fingerprint sensor.

The interface 1177 may support one or more specified protocols to be used by the electronic device 1101 to couple with an external electronic device (e.g., the electronic device 1102) directly (e.g., by wire) or wirelessly. According to an embodiment, the interface 1177 may include, for example, a high-definition multimedia interface (HDMI), a universal serial bus (USB) interface, a secure digital (SD) card interface, or an audio interface.

The connecting terminal 1178 may include a connector via which the electronic device 1101 may physically connect to an external electronic device (e.g., the electronic device 1102). According to an embodiment, the connecting terminal 1178 may include, for example, an HDMI connector, a USB connector, an SD card connector, or an audio connector (e.g., a headphones connector).

The haptic module 1179 may convert an electric signal into a mechanical stimulus (e.g., a vibration or a movement) or an electrical stimulus, which may be recognized by a user via their tactile sensation or kinesthetic sensation. According to an embodiment, the haptic module 1179 may include, for example, a motor, a piezoelectric element, or an electric stimulator.

The camera module 1180 may capture a still image and moving images. According to an embodiment, the camera module 1180 may include one or more lenses, image sensors, ISPs, and flashes.

The power management module 1188 may manage power supplied to the electronic device 1101. According to an embodiment, the power management module 1188 may be implemented as, for example, at least a part of a power management integrated circuit (PMIC).

The battery 1189 may supply power to at least one component of the electronic device 1101. According to an embodiment, the battery 1189 may include, for example, a primary cell, which is not rechargeable, a secondary cell, which is rechargeable, or a fuel cell.

The communication module 1190 may support establishing a direct (e.g., wired) communication channel or a wireless communication channel between the electronic device 1101 and an external electronic device (e.g., the electronic device 1102, the electronic device 1104, or the server 1108) and performing communication via the established communication channel. The communication module 1190 may include one or more CPs that are operable independently from the processor 1120 (e.g., an AP) and that support direct (e.g., wired) communication or wireless communication. According to an embodiment, the communication module 1190 may include a wireless communication module 1192 (e.g., a cellular communication module, a short-range wireless communication module, or a global navigation satellite system (GNSS) communication module) or a wired communication module 1194 (e.g., a local area network (LAN) communication module or a power line communication (PLC) module). A corresponding one of these communication modules may communicate with the external electronic device, for example, the electronic device 1104, via the first network 1198 (e.g., a short-range communication network, such as Bluetooth^{™}, wireless-fidelity (Wi-Fi) direct, or infrared data association (IrDA)) or the second network 1199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip), or may be implemented as multiple components (e.g., multiple chips) separate from each other. The wireless communication module 1192 may identify and authenticate the electronic device 1101 in a communication network, such as the first network 1198 or the second network 1199, using subscriber information (e.g., international mobile subscriber identity (IMSI)) stored in the SIM 1196.

The wireless communication module 1192 may support a 5G network after a 4G network and next-generation communication technology (e.g., new radio (NR) access technology). The NR access technology may support enhanced mobile broadband (eMBB), massive machine type communications (mMTC), or ultra-reliable and low-latency communications (URLLC). The wireless communication module 1192 may support a high-frequency band (e.g., a mmWave band) to achieve, e.g., a high data transmission rate. The wireless communication module 1192 may support various technologies for securing performance on a high-frequency band, such as, e.g., beamforming, massive multiple-input and multiple-output (MIMO), full dimensional MIMO (FD-MIMO), an antenna array, analog beamforming, or a large-scale antenna. The wireless communication module 1192 may support various requirements specified in the electronic device 1101, an external electronic device (e.g., the electronic device 1104), or a network system (e.g., the second network 1199). According to an embodiment, the wireless communication module 1192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 1197 may transmit or receive a signal or power to or from the outside (e.g., an external electronic device) of the electronic device 1101. According to an embodiment, the antenna module 1197 may include an antenna including a radiating element including a conductive material or a conductive pattern formed in or on a substrate (e.g., a printed circuit board (PCB)). According to an embodiment, the antenna module 1197 may include a plurality of antennas (e.g., an antenna array). In such a case, at least one antenna appropriate for a communication scheme used in a communication network, such as the first network 1198 or the second network 1199, may be selected by, for example, the communication module 1190 from the plurality of antennas. The signal or power may be transmitted or received between the communication module 1190 and the external electronic device via the at least one selected antenna. According to an embodiment, another component (e.g., a radio frequency integrated circuit (RFIC)) other than the radiating element may be additionally formed as a part of the antenna module 1197.

According to various embodiments, the antenna module 1197 may form a mmWave antenna module. According to an embodiment, the mmWave antenna module may include a PCB, an RFIC on a first surface (e.g., a bottom surface) of the PCB, or adjacent to the first surface of the PCB and capable of supporting a designated high-frequency band (e.g., a mmWave band), and a plurality of antennas (e.g., an antenna array) disposed on a second surface (e.g., a top or a side surface) of the PCB, or adjacent to the second surface of the PCB and capable of transmitting or receiving signals in the designated high-frequency band.

At least some of the above-described components may be coupled mutually and exchange signals (e.g., commands or data) therebetween via an inter-peripheral communication scheme (e.g., a bus, general-purpose input and output (GPIO), serial peripheral interface (SPI), or mobile industry processor interface (MIPI)).

According to an embodiment, commands or data may be transmitted or received between the electronic device 1101 and the external electronic device (e.g., the electronic device 1104) via the server 1108 coupled with the second network 1199. Each of the external electronic devices (e.g., the electronic device 1102 and 1104) may be a device of the same type as or a different type from the electronic device 1101. According to an embodiment, all or some of operations to be executed by the electronic device 1101 may be executed by one or more of the external electronic devices (e.g., the electronic devices 1102 and 1104, and the server 1108). For example, if the electronic device 1101 needs to perform a function or a service automatically, or in response to a request from a user or another device, the electronic device 1101, instead of, or in addition to, executing the function or the service, may request one or more external electronic devices to perform at least a part of the function or service. The one or more external electronic devices receiving the request may perform the at least part of the function or service requested, or an additional function or an additional service related to the request, and may transfer a result of the performance to the electronic device 1101. The electronic device 1101 may provide the result, with or without further processing of the result, as at least a part of a response to the request. To that end, cloud computing, distributed computing, mobile edge computing (MEC), or client-server computing technology may be used, for example. The electronic device 1101 may provide ultra-low latency services using, e.g., distributed computing or MEC. In an embodiment, the external electronic device (e.g., the electronic device 1104) may include an Internet-of-things (IoT) device. The server 1108 may be an intelligent server using machine learning and/or a neural network. According to an embodiment, the external electronic device (e.g., the electronic device 1104) or the server 1108 may be included in the second network 1199. The electronic device 1101 may be applied to intelligent services (e.g., a smart home, a smart city, a smart car, or healthcare) based on 5G communication technology or IoT-related technology.

According to various embodiments described herein, an electronic device may be a device of one of various types. The electronic device may include, as non-limiting examples, a portable communication device (e.g., a smartphone, etc.), a computing device, a portable multimedia device, a portable medical device, a camera, a wearable device, a home appliance, or the like. However, the electronic device is not limited to the examples described above.

It should be appreciated that various embodiments of the present disclosure and the terms used therein are not intended to limit the technological features set forth herein to particular embodiments. The scope of protection is defined in the appended claims. In connection with the description of the drawings, like reference numerals may be used for similar or related components. It is to be understood that a singular form of a noun corresponding to an item may include one or more of the things unless the relevant context clearly indicates otherwise. As used herein, "A or B," "at least one of A and B," "at least one of A or B," "A, B, or C," "at least one of A, B, and C," and "A, B, or C," each of which may include any one of the items listed together in the corresponding one of the phrases, or all possible combinations thereof. Terms such as "first," "second," or "initial" or "next" or "subsequent" may simply be used to distinguish the component from other components in question, and do not limit the components in other aspects (e.g., importance or order). It is to be understood that if an element (e.g., a first element) is referred to, with or without the term "operatively" or "communicatively," as "coupled with," "coupled to," "connected with," or "connected to" another element (e.g., a second element), the element may be coupled with the other element directly (e.g., by wire), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry." A module may be a single integral component, or a minimum unit or part thereof, adapted to perform one or more functions. For example, according to an embodiment, the module may be implemented in the form of an application-specific integrated circuit (ASIC).

Various embodiments set forth herein may be implemented as software (e.g., the program 1140) including one or more instructions that are stored in a storage medium (e.g., the internal memory 1136 or the external memory 1138) that is readable by a machine (e.g., the electronic device 1101). For example, a processor (e.g., the processor 1120) of the machine (e.g., the electronic device 1101) may invoke at least one of the one or more instructions stored in the storage medium and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to various embodiments, a method according to an embodiment of the disclosure may be included and provided in a computer program product. The computer program product may be traded as a product between a seller and a buyer. The computer program product may be distributed in the form of a machine-readable storage medium (e.g., a compact disc read-only memory (CD-ROM)), or be distributed (e.g., downloaded or uploaded) online via an application store (e.g., PlayStore^{™}) or between two user devices (e.g., smart phones) directly. If distributed online, at least part of the computer program product may be temporarily generated or at least temporarily stored in the machine-readable storage medium, such as a memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A wireless communication device (100), comprising:
a communication processor (105); and
a transceiver (110) configured to be controlled by the communication processor (105) to perform wireless communication,
wherein the transceiver (110) comprises:
a phase locked loop, PLL, circuit (210) configured to generate a first oscillator signal (220) based on a clock frequency signal;
a radio frequency, RF, transmission signal generation circuit (205) configured to generate an RF transmission signal (Tx) based on the first oscillator signal received from the PLL circuit and a baseband transmission signal received from the communication processor; and
a first decision circuit (280) configured to receive, from a first phase comparator (285) comprised in the PLL circuit (210), a first phase comparison signal (286) indicating whether a phase of the first oscillator signal (220) is locked, and control activation of at least one component comprised in the RF transmission signal generation circuit (205) based on the first phase comparison signal (286).

2. The wireless communication device of claim 1, wherein the first decision circuit (280) is further configured to:
in response to the phase of the first oscillator signal (220) being locked, activate at least one component comprised in the RF transmission signal generation circuit (205); and
in response to the phase of the first oscillator signal (220) not being locked, deactivate at least one component comprised in the RF transmission signal generation circuit (205).

3. The wireless communication device of claim 1 or 2, wherein the first phase comparator (285) is configured to:
in response to a phase difference between the clock frequency signal and the first oscillator signal being maintained within a set range for a set time, output the first phase comparison signal of a first value; and
in response to the phase difference between the clock frequency signal and the first oscillator signal not being maintained within the set range for the set time, output the first phase comparison signal of a second value.

4. The wireless communication device of any one of claims 1-3, wherein the first decision circuit (280) is further configured to:
in response to the phase of the first oscillator signal being locked, activate at least one of an amplifier, a voltage converter, or a mixer comprised in the RF transmission signal generation circuit; and
in response to the phase of the first oscillator signal not being locked, deactivate at least one of the amplifier, the voltage converter, or the mixer comprised in the RF transmission signal generation circuit.

5. The wireless communication device of any one of claims 1-4, wherein the PLL circuit (210) is further configured to generate a second oscillator signal (235) based on the clock frequency signal,
wherein the wireless communication device (100) further comprises an RF reception signal processing circuit (215) configured to generate a baseband reception signal based on the second oscillator signal (235) received from the PLL circuit and an RF signal received from the outside,
wherein the first decision circuit (280) is further configured to:
receive, from a second phase comparator (295) comprised in the PLL circuit (210), a second phase comparison signal (296) indicating whether a phase of the second oscillator signal (235) is locked; and
control activation of at least one component comprised in the RF transmission signal generation circuit (205) based on the first phase comparison signal (286) and the second phase comparison signal (296).

6. The wireless communication device of claim 5, wherein the first decision circuit (280) is further configured to:
in response to the phase of the first oscillator signal (220) and the phase of the second oscillator signal (235) being locked, activate at least one component comprised in the RF transmission signal generation circuit (205); and
in response to at least one of the phase of the first oscillator signal (220) or the phase of the second oscillator signal (235) not being locked, deactivate at least one component comprised in the RF transmission signal generation circuit (205).

7. The wireless communication device of claim 5, wherein the communication processor further comprises:
a complex signal generator configured to generate a complex signal;
a first frequency shifter configured to shift a frequency of the complex signal to generate the baseband transmission signal;
a modulator configured to modulate the complex signal;
a second frequency shifter configured to shift a frequency of the modulated complex signal to generate the baseband transmission signal; and
a second decision circuit configured to detect whether the first frequency shifter operates and whether the second frequency shifter operates, and transfer a detection result signal indicating a result of the detecting to the first decision circuit,
wherein the first decision circuit is further configured to:
in response to any one of the first frequency shifter and the second frequency shifter operating and the phase of the first oscillator signal and the phase of the second oscillator signal being locked, activate at least one component comprised in the RF transmission signal generation circuit.

8. The wireless communication device of claim 7, wherein the detection result signal is transferred to the first decision circuit through a digital interface that connects the communication processor and the transceiver.

9. The wireless communication device of any one of claims 1-8, wherein the PLL circuit further comprises:
an oscillator configured to generate the first oscillator signal based on an output signal of the first phase comparator;
a divider configured to lower a frequency of the first oscillator signal and transfer the first oscillator signal with the lowered frequency to the first phase comparator; and
a loop filter configured to remove noise comprised in the output signal of the first phase comparator.

10. The wireless communication device of any one of claims 1-9, wherein the first decision circuit is further configured to:
control power to be supplied to the at least one component; or
control activation of the at least one component by controlling a bias voltage or bias current to be supplied to the at least one component.

11. A method of controlling activation of a radio frequency, RF, transmission signal generation circuit (205) comprised in a transceiver (110) of a wireless communication device (100) configured to perform wireless communication, the method comprising:
comparing, by a first phase comparator (285) in a phase locked loop, PLL, circuit (210) of the transceiver (110), a phase of a clock frequency signal and a phase of a first oscillator signal (220) that is an output signal of the PLL circuit (210), and generating a first phase comparison signal (286) indicating whether the phase of the first oscillator signal (220) is locked;
transferring, by the first phase comparator (285), the first phase comparison signal (286) to a first decision circuit (280) of the transceiver (110);
controlling, by the first decision circuit (280), activation of at least one component comprised in the RF transmission signal generation circuit (205) based on whether the phase of the first oscillator signal (220) indicated in the first phase comparison signal (286) is locked;
in response to the at least one component being activated, generating, by the RF transmission signal generation circuit (205), an RF transmission signal from the first oscillator signal (220) and a baseband transmission signal generated by a communication processor (105) of the wireless communication device (100); and
outputting, by the RF transmission signal generation circuit (205), the generated RF transmission signal.

12. The method of claim 11, wherein the controlling the activation of the at least one component comprises:
in response to the phase of the first oscillator signal being locked, activating, by the first decision circuit, at least one component comprised in the RF transmission signal generation circuit; and
in response to the phase of the first oscillator signal not being locked, deactivating at least one component comprised in the RF transmission signal generation circuit.

13. The method of claim 11 or 12, wherein the generating the first phase comparison signal comprises:
in response to a value of the first phase comparison signal being maintained within a set range for a set time, generating the first oscillator signal of a first value; and
in response to the value of the first phase comparison signal not being maintained within the set range for the set time, generating the first oscillator signal of a second value.

14. The method of any one of claims 11-13, wherein the controlling the activation of the at least one component comprises:
in response to the phase of the first oscillator signal being locked, activating, by the first decision circuit, at least one of an amplifier, a voltage converter, or a mixer comprised in the RF transmission signal generation circuit; and
in response to the phase of the first oscillator signal not being locked, deactivating at least one of the amplifier, the voltage converter, or the mixer comprised in the RF transmission signal generation circuit.

15. A non-transitory computer-readable storage medium storing instructions that, when executed by a processor, cause the processor to perform the method of any one of claims 11-14.

## Patentansprüche

1. Drahtlose Kommunikationsvorrichtung (100), die Folgendes umfasst:
einen Kommunikationsprozessor (105); und
einen Transceiver (110), der so konfiguriert ist, dass er von dem Kommunikationsprozessor (105) gesteuert wird, um eine drahtlose Kommunikation auszuführen,
wobei der Transceiver (110) Folgendes umfasst:
eine Phasenregelschleifen(PLL)-Schaltung (210), die so konfiguriert ist, dass sie ein erstes Oszillatorsignal (220) basierend auf einem Taktfrequenzsignal erzeugt;
eine Hochfrequenz(HF)-Übertragungssignalerzeugungsschaltung (205), die so konfiguriert ist, dass sie ein HF-Übertragungssignal (Tx) basierend auf dem von der PLL-Schaltung empfangenen ersten Oszillatorsignal und einem von dem Kommunikationsprozessor empfangenen Basisband-Übertragungssignal erzeugt; und
eine erste Entscheidungsschaltung (280), die so konfiguriert ist, dass sie von einem in der PLL-Schaltung (210) enthaltenen ersten Phasenkomparator (285) ein erstes Phasenvergleichssignal (286) empfängt, das anzeigt, ob eine Phase des ersten Oszillatorsignals (220) verriegelt ist, und die Aktivierung mindestens einer in der HF-Übertragungssignalerzeugungsschaltung (205) enthaltenen Komponente basierend auf dem ersten Phasenvergleichssignal (286) steuert.

2. Drahtlose Kommunikationsvorrichtung nach Anspruch 1, wobei die erste Entscheidungsschaltung (280) ferner zu Folgendem konfiguriert ist:
als Reaktion darauf, dass die Phase des ersten Oszillatorsignals (220) verriegelt ist, Aktivieren mindestens einer in der HF-Übertragungssignalerzeugungsschaltung (205) enthaltenen Komponente; und
als Reaktion darauf, dass die Phase des ersten Oszillatorsignals (220) nicht verriegelt ist, Deaktivieren mindestens einer in der HF-Übertragungssignalerzeugungsschaltung (205) enthaltenen Komponente.

3. Drahtlose Kommunikationsvorrichtung nach Anspruch 1 oder 2, wobei der erste Phasenkomparator (285) zu Folgendem konfiguriert ist:
als Reaktion darauf, dass eine Phasendifferenz zwischen dem Taktfrequenzsignal und dem ersten Oszillatorsignal für eine festgelegte Zeit in einem festgelegten Bereich gehalten wird, Ausgeben des ersten Phasenvergleichssignals mit einem ersten Wert; und
als Reaktion darauf, dass die Phasendifferenz zwischen dem Taktfrequenzsignal und dem ersten Oszillatorsignal für die festgelegte Zeit nicht in dem festgelegten Bereich gehalten wird, Ausgeben des ersten Phasenvergleichssignals mit einem zweiten Wert.

4. Drahtlose Kommunikationsvorrichtung nach einem der Ansprüche 1-3, wobei die erste Entscheidungsschaltung (280) ferner zu Folgendem konfiguriert ist:
als Reaktion darauf, dass die Phase des ersten Oszillatorsignals verriegelt ist, Aktivieren eines Verstärkers, eines Spannungswandlers und/oder eines Mischers, die in der HF-Übertragungssignalerzeugungsschaltung enthalten sind; und
als Reaktion darauf, dass die Phase des ersten Oszillatorsignals nicht verriegelt ist, Deaktivieren des Verstärkers, des Spannungswandlers und/oder des Mischers, die in der HF-Übertragungssignalerzeugungsschaltung enthalten sind.

5. Drahtlose Kommunikationsvorrichtung nach einem der Ansprüche 1-4, wobei die PLL-Schaltung (210) ferner so konfiguriert ist, dass sie ein zweites Oszillatorsignal (235) basierend auf dem Taktfrequenzsignal erzeugt,
wobei die drahtlose Kommunikationsvorrichtung (100) ferner eine **HF-**Empfangssignalverarbeitungsschaltung (215) umfasst, die so konfiguriert ist, dass sie ein Basisband-Empfangssignal basierend auf dem von der PLL-Schaltung empfangenen zweiten Oszillatorsignal (235) und einem von außen empfangenen **HF-**Signal erzeugt,
wobei die erste Entscheidungsschaltung (280) ferner zu Folgendem konfiguriert ist:
Empfangen eines zweiten Phasenvergleichssignals (296), das anzeigt, ob eine Phase des zweiten Oszillatorsignals (235) verriegelt ist, von einem in der PLL-Schaltung (210) enthaltenen zweiten Phasenkomparator (295); und
Steuern der Aktivierung mindestens einer in der **HF-**Übertragungssignalerzeugungsschaltung (205) enthaltenen Komponente basierend auf dem ersten Phasenvergleichssignal (286) und dem zweiten Phasenvergleichssignal (296).

6. Drahtlose Kommunikationsvorrichtung nach Anspruch 5, wobei die erste Entscheidungsschaltung (280) ferner zu Folgendem konfiguriert ist:
als Reaktion darauf, dass die Phase des ersten Oszillatorsignals (220) und die Phase des zweiten Oszillatorsignals (235) verriegelt sind, Aktivieren mindestens einer in der HF-Übertragungssignalerzeugungsschaltung (205) enthaltenen Komponente; und
als Reaktion darauf, dass die Phase des ersten Oszillatorsignals (220) und/oder die Phase des zweiten Oszillatorsignals (235) nicht verriegelt sind, Deaktivieren mindestens einer in der HF-Übertragungssignalerzeugungsschaltung (205) enthaltenen Komponente.

7. Drahtlose Kommunikationsvorrichtung nach Anspruch 5, wobei der Kommunikationsprozessor ferner Folgendes umfasst:
einen komplexen Signalgenerator, der zum Erzeugen eines komplexen Signals konfiguriert ist;
einen ersten Frequenzschieber, der so konfiguriert ist, dass er eine Frequenz des komplexen Signals verschiebt, um das Basisband-Übertragungssignal zu erzeugen;
einen Modulator, der zum Modulieren des komplexen Signals konfiguriert ist;
einen zweiten Frequenzschieber, der so konfiguriert ist, dass er eine Frequenz des modulierten komplexen Signals verschiebt, um das Basisband-Übertragungssignal zu erzeugen; und
eine zweite Entscheidungsschaltung, die so konfiguriert ist, dass sie erkennt, ob der erste Frequenzschieber arbeitet und ob der zweite Frequenzschieber arbeitet, und ein Erkennungsergebnissignal, das ein Ergebnis der Erkennung anzeigt, an die erste Entscheidungsschaltung überträgt,
wobei die erste Entscheidungsschaltung ferner zu Folgendem konfiguriert ist:
als Reaktion darauf, dass der erste Frequenzschieber oder der zweite Frequenzschieber arbeitet und die Phase des ersten Oszillatorsignals und die Phase des zweiten Oszillatorsignals verriegelt sind, Aktivieren mindestens einer in der HF-Übertragungssignalerzeugungsschaltung enthaltenen Komponente.

8. Drahtlose Kommunikationsvorrichtung nach Anspruch 7, wobei das Erkennungsergebnissignal über eine digitale Schnittstelle, die den Kommunikationsprozessor und den Transceiver verbindet, an die erste Entscheidungsschaltung übertragen wird.

9. Drahtlose Kommunikationsvorrichtung nach einem der Ansprüche 1-8, wobei die PLL-Schaltung ferner Folgendes umfasst:
einen Oszillator, der so konfiguriert ist, dass er das erste Oszillatorsignal basierend auf einem Ausgangssignal des ersten Phasenkomparators erzeugt;
einen Teiler, der so konfiguriert ist, dass er eine Frequenz des ersten Oszillatorsignals absenkt und das erste Oszillatorsignal mit der abgesenkten Frequenz an den ersten Phasenkomparator überträgt; und
einen Schleifenfilter, der so konfiguriert ist, dass er das in dem Ausgangssignal des ersten Phasenkomparators enthaltene Rauschen entfernt.

10. Drahtlose Kommunikationsvorrichtung nach einem der Ansprüche 1-9, wobei die erste Entscheidungsschaltung ferner zu Folgendem konfiguriert ist:
Steuern der Leistung, die der mindestens einen Komponente zugeführt werden soll; oder
Steuern der Aktivierung der mindestens einen Komponente durch Steuern einer Vorspannung oder eines Vorspannungsstroms, der der mindestens einen Komponente zugeführt werden soll.

11. Verfahren zum Steuern der Aktivierung einer Hochfrequenz(HF)-Übertragungssignalerzeugungsschaltung (205), die in einem Transceiver (110) einer drahtlosen Kommunikationsvorrichtung (100) enthalten ist, die zum Ausführen einer drahtlosen Kommunikation konfiguriert ist, wobei das Verfahren Folgendes umfasst:
Vergleichen einer Phase eines Taktfrequenzsignals und einer Phase eines ersten Oszillatorsignals (220), das ein Ausgangssignal der PLL-Schaltung (210) ist, durch einen ersten Phasenkomparator (285) in einer Phasenregelschleifen(PLL)-Schaltung (210) des Transceivers (110), und Erzeugen eines ersten Phasenvergleichssignals (286), das anzeigt, ob die Phase des ersten Oszillatorsignals (220) verriegelt ist;
Übertragen des ersten Phasenvergleichssignals (286) durch den ersten Phasenkomparator (285) an eine erste Entscheidungsschaltung (280) des Transceivers (110);
Steuern der Aktivierung mindestens einer in der **HF-**Übertragungssignalerzeugungsschaltung (205) enthaltenen Komponente durch die erste Entscheidungsschaltung (280) basierend darauf, ob die Phase des in dem ersten Phasenvergleichssignal (286) angezeigten ersten Oszillatorsignals (220) verriegelt ist;
als Reaktion auf die Aktivierung der mindestens einen Komponente, Erzeugen eines HF-Übertragungssignals durch die **HF-**Übertragungssignalerzeugungsschaltung (205) aus dem ersten Oszillatorsignal (220) und einem von einem Kommunikationsprozessor (105) der drahtlosen Kommunikationsvorrichtung (100) erzeugten Basisband-Übertragungssignal; und
Ausgeben des erzeugten HF-Übertragungssignals durch die **HF-**Übertragungssignalerzeugungsschaltung (205).

12. Verfahren nach Anspruch 11, wobei das Steuern der Aktivierung der mindestens einen Komponente Folgendes umfasst:
als Reaktion darauf, dass die Phase des ersten Oszillatorsignals verriegelt ist, Aktivieren mindestens einer in der HF-Übertragungssignalerzeugungsschaltung enthaltenen Komponente durch die erste Entscheidungsschaltung; und
als Reaktion darauf, dass die Phase des ersten Oszillatorsignals nicht verriegelt ist, Deaktivieren mindestens einer in der HF-Übertragungssignalerzeugungsschaltung enthaltenen Komponente.

13. Verfahren nach Anspruch 11 oder 12, wobei das Erzeugen des ersten Phasenvergleichssignals Folgendes umfasst:
als Reaktion darauf, dass ein Wert des ersten Phasenvergleichssignals für eine festgelegte Zeit in einem festgelegten Bereich gehalten wird, Erzeugen des ersten Oszillatorsignals mit einem ersten Wert; und
als Reaktion darauf, dass der Wert des ersten Phasenvergleichssignals für die festgelegte Zeit nicht in dem festgelegten Bereich gehalten wird, Erzeugen des ersten Oszillatorsignals mit einem zweiten Wert.

14. Verfahren nach einem der Ansprüche 11-13, wobei das Steuern der Aktivierung der mindestens einen Komponente Folgendes umfasst:
als Reaktion darauf, dass die Phase des ersten Oszillatorsignals verriegelt ist, Aktivieren eines Verstärkers, eines Spannungswandlers und/oder eines Mischers, die in der HF-Übertragungssignalerzeugungsschaltung enthalten sind, durch die erste Entscheidungsschaltung; und
als Reaktion darauf, dass die Phase des ersten Oszillatorsignals nicht verriegelt ist, Deaktivieren des Verstärkers, des Spannungswandlers und/oder des Mischers, die in der HF-Übertragungssignalerzeugungsschaltung enthalten sind.

15. Nichtflüchtiges computerlesbares Speichermedium, das Anweisungen speichert, die, wenn sie von einem Prozessor ausgeführt werden, den Prozessor veranlassen, das Verfahren nach einem der Ansprüche 11-14 auszuführen.

## Revendications

1. Dispositif de communication sans fil (100), comprenant :
un processeur de communication (105) ; et
un émetteur-récepteur (110) configuré pour être commandé par le processeur de communication (105) pour effectuer une communication sans fil,
où l'émetteur-récepteur (110) comprend :
un circuit de boucle à verrouillage de phase, PLL, (210) configuré pour générer un premier signal d'oscillateur (220) sur la base d'un signal de fréquence d'horloge ;
un circuit de génération de signal de transmission radiofréquence, RF, (205) configuré pour générer un signal de transmission RF (Tx) sur la base du premier signal d'oscillateur reçu du circuit PLL et un signal de transmission de bande de base reçu du processeur de communication ; et
un premier circuit de décision (280) configuré pour recevoir, d'un premier comparateur de phase (285) compris dans le circuit PLL (210), un premier signal de comparaison de phase (286) indiquant si une phase du premier signal d'oscillateur (220) est verrouillée, et commander l'activation d'au moins un composant compris dans le circuit de génération de signal de transmission RF (205) sur la base du premier signal de comparaison de phase (286).

2. Dispositif de communication sans fil selon la revendication 1, où le premier circuit de décision (280) est en outre configuré pour :
en réponse au verrouillage de la phase du premier signal d'oscillateur (220), activer au moins un composant compris dans le circuit de génération de signal de transmission RF (205) ; et
en réponse au non-verrouillage de la phase du premier signal d'oscillateur (220), désactiver au moins un composant compris dans le circuit de génération de signal de transmission RF (205).

3. Dispositif de communication sans fil selon la revendication 1 ou 2, où le premier comparateur de phase (285) est configuré pour :
en réponse au maintien d'une différence de phase entre le signal de fréquence d'horloge et le premier signal d'oscillateur dans une plage définie pendant un temps défini, émettre le premier signal de comparaison de phase d'une première valeur ; et
en réponse au non-maintien de la différence de phase entre le signal de fréquence d'horloge et le premier signal d'oscillateur dans la plage définie pendant un temps défini, émettre le premier signal de comparaison de phase d'une deuxième valeur.

4. Dispositif de communication sans fil selon l'une quelconque des revendications 1 à 3, où le premier circuit de décision (280) est en outre configuré pour :
en réponse au verrouillage de la phase du premier signal d'oscillateur, activer au moins un parmi un amplificateur, un convertisseur de tension, ou un mélangeur compris dans le circuit de génération de signal de transmission RF ; et
en réponse au non-verrouillage de la phase du premier signal d'oscillateur, désactiver au moins l'un parmi l'amplificateur, le convertisseur de tension, ou le mélangeur compris dans le circuit de génération de signal de transmission RF.

5. Dispositif de communication sans fil selon l'une quelconque des revendications 1 à 4, où le circuit PLL (210) est en outre configuré pour générer un deuxième signal d'oscillateur (235) sur la base du signal de fréquence d'horloge,
où le dispositif de communication sans fil (100) comprend en outre un circuit de traitement de signal de réception RF (215) configuré pour générer un signal de réception de bande de base sur la base du deuxième signal d'oscillateur (235) reçu du circuit PLL et d'un signal RF reçu de l'extérieur,
où le premier circuit de décision (280) est en outre configuré pour :
recevoir, d'un deuxième comparateur de phase (295) compris dans le circuit PLL (210), un deuxième signal de comparaison de phase (296) indiquant si une phase du deuxième signal d'oscillateur (235) est verrouillée ; et
commander l'activation d'au moins un composant compris dans le circuit de génération de signal de transmission RF (205) sur la base du premier signal de comparaison de phase (286) et du deuxième signal de comparaison de phase (296).

6. Dispositif de communication sans fil selon la revendication 5, où le premier circuit de décision (280) est en outre configuré pour :
en réponse au verrouillage de la phase du premier signal d'oscillateur (220) et de la phase du deuxième signal d'oscillateur (235), activer au moins un composant compris dans le circuit de génération de signal de transmission RF (205) ; et
en réponse au non-verrouillage d'au moins un parmi la phase du premier signal d'oscillateur (220) ou la phase du deuxième signal d'oscillateur (235), désactiver au moins un composant compris dans le circuit de génération de signal de transmission RF (205).

7. Dispositif de communication sans fil selon la revendication 5, où le processeur de communication comprend en outre :
un générateur de signal complexe configuré pour générer un signal complexe ;
un premier décaleur de fréquence configuré pour décaler une fréquence du signal complexe pour générer le signal de transmission de bande de base ;
un modulateur configuré pour moduler le signal complexe ;
un deuxième décaleur de fréquence configuré pour décaler une fréquence du signal complexe modulé pour générer le signal de transmission de bande de base ; et
un deuxième circuit de décision configuré pour détecter si le premier décaleur de fréquence fonctionne et si le deuxième décaleur de fréquence fonctionne, et transférer un signal de résultat de détection indiquant un résultat de la détection au premier circuit de décision,
où le premier circuit de décision est en outre configuré pour :
en réponse au fonctionnement de l'un quelconque du premier décaleur de fréquence et du deuxième décaleur de fréquence et au verrouillage de la phase du premier signal d'oscillateur et de la phase du deuxième signal d'oscillateur, activer au moins un composant compris dans le circuit de génération de signal de transmission RF.

8. Dispositif de communication sans fil selon la revendication 7, où le signal de résultat de détection est transféré au premier circuit de décision par l'intermédiaire d'une interface numérique qui connecte le processeur de communication et l'émetteur-récepteur.

9. Dispositif de communication sans fil selon l'une quelconque des revendications 1 à 8, où le circuit PLL comprend en outre :
un oscillateur configuré pour générer le premier signal d'oscillateur sur la base d'un signal de sortie du premier comparateur de phase ;
un diviseur configuré pour abaisser une fréquence du premier signal d'oscillateur et transférer le premier signal d'oscillateur avec la fréquence abaissée au premier comparateur de phase ; et
un filtre de boucle configuré pour éliminer le bruit compris dans le signal de sortie du premier comparateur de phase.

10. Dispositif de communication sans fil selon l'une quelconque des revendications 1 à 9, où le premier circuit de décision est en outre configuré pour :
commander l'alimentation électrique de l'au moins un composant ; ou
commander l'activation de l'au moins un composant en commandant de fournir une tension de polarisation ou un courant de polarisation à l'au moins un composant.

11. Méthode de commande d'activation d'un circuit de génération de signal de transmission radiofréquence, RF, (205) compris dans un émetteur-récepteur (110) d'un dispositif de communication sans fil (100) configuré pour effectuer une communication sans fil, le procédé comprenant :
comparer, par un premier comparateur de phase (285) dans un circuit de boucle à verrouillage de phase, PLL, (210) de l'émetteur-récepteur (110), une phase d'un signal de fréquence d'horloge et une phase d'un premier signal d'oscillateur (220) qui est un signal de sortie du circuit PLL (210), et générer un premier signal de comparaison de phase (286) indiquant si la phase du premier signal d'oscillateur (220) est verrouillée ;
transférer, par le premier comparateur de phase (285), le premier signal de comparaison de phase (286) à un premier circuit de décision (280) de l'émetteur-récepteur (110) ;
commander, par le premier circuit de décision (280), l'activation d'au moins un composant compris dans le circuit de génération de signal de transmission RF (205) sur la base de si la phase du premier signal d'oscillateur (220) indiqué dans le premier signal de comparaison de phase (286) est verrouillée ;
en réponse à l'activation de l'au moins un composant, générer, par le circuit de génération de signal de transmission RF (205), un signal de transmission RF à partir du premier signal d'oscillateur (220) et un signal de transmission de bande de base généré par un processeur de communication (105) du dispositif de communication sans fil (100) ; et
émettre, par le circuit de génération de signal de transmission RF (205), le signal de transmission RF généré.

12. Procédé selon la revendication 11, où la commande de l'activation de l'au moins un composant comprend :
en réponse au verrouillage de la phase du premier signal d'oscillateur, activer, par le premier circuit de décision, au moins un composant compris dans le circuit de génération de signal de transmission RF ; et
en réponse au non-verrouillage de la phase du premier signal d'oscillateur, désactiver au moins un composant compris dans le circuit de génération de signal de transmission RF.

13. Procédé selon la revendication 11 ou 12, où la génération du premier signal de comparaison de phase comprend :
en réponse au maintien d'une valeur du premier signal de comparaison de phase dans une plage définie pendant un temps défini, générer le premier signal d'oscillateur d'une première valeur ; et
en réponse au non-maintien de la valeur du premier signal de comparaison de phase dans la plage définie pendant un temps défini, générer le premier signal d'oscillateur d'une deuxième valeur.

14. Procédé selon l'une quelconque des revendications 11 à 13, où la commande de l'activation de l'au moins un composant comprend :
en réponse au verrouillage de la phase du premier signal d'oscillateur, activer, par le premier circuit de décision, au moins un parmi un amplificateur, un convertisseur de tension, ou un mélangeur compris dans le circuit de génération de signal de transmission RF ; et
en réponse au non-verrouillage de la phase du premier signal d'oscillateur, désactiver au moins l'un parmi l'amplificateur, le convertisseur de tension, ou le mélangeur compris dans le circuit de génération de signal de transmission RF.

15. Support de stockage non transitoire lisible par ordinateur stockant des instructions qui, lorsqu'elles sont exécutées par un processeur, amènent le processeur à effectuer le procédé selon l'une quelconque des revendications 11 à 14.
